(19) **Europäisches Patentamt**
**European Patent Office**
**Office européen des brevets**

(11) **EP 1 533 898 A1**

(12) **EUROPEAN PATENT APPLICATION**
published in accordance with Art. 158(3) EPC

(43) Date of publication:
**25.05.2005 Bulletin 2005/21**

(51) Int Cl.[7]: **H03H 17/06**

(21) Application number: **03764193.3**

(86) International application number:
**PCT/JP2003/008922**

(22) Date of filing: **14.07.2003**

(87) International publication number:
**WO 2004/008637 (22.01.2004 Gazette 2004/04)**

(84) Designated Contracting States:
**AT BE BG CH CY CZ DE DK EE ES FI FR GB GR HU IE IT LI LU MC NL PT RO SE SI SK TR**

(30) Priority: **15.07.2002 JP 2002205014**

(71) Applicant: **Neuro Solution Corp.**
**Tokyo 158-0091 (JP)**

(72) Inventor: **KOYANAGI, Yukio**
**Saitama-shi, Saitama 336-0932 (JP)**

(74) Representative: **VOSSIUS & PARTNER**
**Siebertstrasse 4**
**81675 München (DE)**

(54) **DIGITAL FILTER DESIGNING METHOD, DIGITAL FILTER DESIGNING PROGRAM, DIGITAL FILTER**

(57) According to a basic unit filter having a predetermined basic numeric string as a filter coefficient, a high-pass unit filter (H15) and a low-pass unit filter (L13) having pass bands having a common center frequency Fc are created. These are connected in the cascade way to design a band pass filter. Characteristic values obtained by combining a few types of unit filters are cancelled by each other. Thus, without pulling out a necessary frequency band and only by the cascade connection of the high-pass unit filter (H15) and the low-pass unit filter (L13), it is possible to extract a superimposed portion as a band pass filter pass band.

## F I G. 9 A

k=0
Fs=4Fc

① H15
② L13
③ CASCADE OF H15 & L13

## F I G. 9 B

k=1
Fs=6Fc

① H18
② L15
③ CASCADE OF H18 & L15
④ PULLING OUT BY LPF1

**Description**

[Background of the Invention]

[Field of the Invention]

The present invention relates to a digital filter designing method, digital filter designing program and digital filter, and more particularly, to a method of designing an FIR filter, which comprises a tapped delay line made up of a plurality of delayers and performs multiplying signals of the respective taps several-fold and then adding up the results of multiplication and outputting the addition result.

[Description of the Related Art]

Some kind of digital signal processing is generally performed in various kinds of electronic devices provided in various fields of communication, measurement, sound/image signal processing, medical care, seismology, and so on. One of the most significant basic operation of the digital signal processing is filtering which extracts only a signal having a necessary frequency band from an input signal in which signal and noise are mixed. For this reason, digital filters are often used for electronic devices performing digital signal processing.

As the digital filter, an IIR (Infinite Impulse Response) filter and FIR (Finite Impulse Response) filter are often used. Of these digital filters, the FIR filter is a filter provided with tapped delay lines made up of a plurality of delayers, multiplies signals of the respective taps several-fold and adds up the results of multiplication and outputs the addition result, and has the following advantages. First, since extreme values of a transfer function of the FIR filter exist only at the origin of the z-plane, the circuit is always stable. Second, it is possible to realize a completely exact linear phase characteristic.

When filters are categorized from the standpoint of an arbandment of a pass band and a stop band, they are classified mainly into four categories of low-pass filters, high-pass filters, band pass filters and band elimination filters. The basic element for an IIR filter or FIR filter is a low-pass filter and other high-pass filter, band pass filter and band elimination filter are derived from the low-pass filter by carrying out processing such as frequency conversion.

Conventionally, when the low-pass filter as the basic element is designed, coefficients of an FIR filter with respect to the respective taps are obtained by carrying out convolutional calculations, etc. , using a window function or Chebyshev approximation, etc. , based on the ratio of a sampling frequency and a cutoff frequency. Then, a simulation is performed using the obtained filter coefficients to correct the coefficient values as appropriate while checking the frequency characteristic to thereby obtain a low-pass filter having a desired characteristic.

Furthermore, when the other filters such as high-pass filter, bandpass filter, band elimination filter are designed, a plurality of low-pass filters as the basic elements are designed using the above described procedure first. Next, by carrying out operations such as frequency conversion by combining those low-pass filters, an FIR filter having a desired frequency characteristic is designed.

However, the above described conventional filter designing method requires an expert technician to perform design with an immense amount of time and effort, causing a problem that it is not easy to design an FIR filter having a desired characteristic.

Furthermore, even if it is possible to design an FIR filter having substantially a desired characteristic, the number of taps of the designed filter becomes enormous and the coefficient values become extremely complicated and random values. For this reason, there is a problem that a large-scale circuit structure (adders, multipliers) is required to realize such a number of taps and coefficient values. Furthermore, there is also a problem that when the designed FIR filter is actually used, the amount of calculation becomes very large and processing load becomes heavy.

Thus, in view of such problems, the present applicant applied for a patent by inventing a filter designing method capable of easily designing an FIR digital filter having a desired frequency characteristic and realizing the desired frequency characteristic with a small circuit scale with a high degree of accuracy (Japanese Patent Application No. 2001-400673).

The present invention further improves the content of this already presented application and it is an object of the present invention to make it possible to realize a desired frequency characteristic with a higher degree of accuracy and design an FIR digital filter having such a frequency characteristic more simply.

[Summary of the Invention]

In order to solve the above described problems , the present invention creates one or more unit filters having a mutually common pass band based on basic unit filters formed by multiplying respective tap signals of a tapped delay line made up of a plurality of delayers several-fold using filter coefficients made up of a predetermined basic numeric string, adding up those multiplication results and outputting the addition result, and connects the one or more unit filters in the cascade way to thereby design a digital filter.

The filter coefficient of the above described basic unit filter consists of a numeric string having a ratio of absolute values, for example, of 1, 1, 8, 8, 1, 1 or a numeric string having a ratio of absolute values of 1, 0, 9, 16, 9, 0, 1.

Furthermore, the above described one or more unit filters include a high-pass unit filter and low-pass unit filter having substantially the same center frequency.

Another aspect of the present invention narrows the band width of the pass band of the above described unit filter by inserting delays corresponding to a few clocks between the respective taps.

According to a further aspect of the present invention, when the unit filter is expressed by YF, the band width of the pass band of the unit filter is widened by cascade connecting the unit filters so as to satisfy a following relationship:

$$a * Yf^i - b * YF^j$$

where the multiplications with respect to YF denote cascade connections of the unit filters, a, b, i, j denote coefficients expressing the numbers of cascade connections of the unit filters and $a > b$, $i < j$.

A still further aspect of the present invention creates a unit filter having a relatively wide pass band based on basic unit filters formed by multiplying respective tap signals of a tapped delay line made up of a plurality of delayers several-fold using filter coefficients made up of a predetermined basic numeric string, adding up those multiplication results and outputting the addition result, designs a high-pass filter and low-pass filter so that their respective pass bands overlap with each other in the pass band of the unit filter, and connects the unit filter, high-pass filter and low-pass filter in the cascade way to thereby design a band pass filter having a pass band made up of a superimposed portion of the respective pass bands.

According to a still further aspect of the present invention, by performing one or both of the operations according to claim 3 and claim 4 on any one or both of the high-pass filter and low-pass filter, the pass band of the band pass filter are fine-adjusted.

A still further aspect of the present invention designs a digital filter by dividing a filter string generated using the above described designing method into one or more blocks and cascade connecting one or more filters which are final generation coefficients for each block.

As described above, the present invention designs a digital filter by cascade connecting one or more unit filters created from a basic unit filter which uses a predetermined basic numeric string as a filter coefficient. Or the invention also designs a high-pass filter and low-pass filter in such a way that the respective pass bands overlap with each other in the pass band of the unit filter having a relatively wide pass band and designs a digital filter by cascade connecting the unit filter, high-pass filter and low-pass filter. Thus, it is possible to obtain a complicated filter coefficient of the digital filter by substantially only combining unit filters and allow even a non-expert technician to design a filter extremely simply.

Furthermore, the present invention requires only an extremely small number of taps necessary for the digital filter to be designed and requires only a small number of types of filter coefficients necessary for each tap output, making the structure of the digital filter considerably simple. Therefore, it is possible to drastically reduce the number of circuit elements (multipliers in particular), reduce the circuit scale, reduce power consumption and alleviate the calculation load, etc. Furthermore, since the digital filter designed has an extremely simple structure made up of a repetition of the same pattern of a unit filter, it is possible to reduce man-hours for integration and facilitate the integration into an IC.

Furthermore, according to another aspect of the present invention, by designing a digital filter by cascade connecting unit filters having a greater number of delays inserted between taps (the number of "0"s inserted between filter coefficients), it is possible to arbitrarily narrow the band width without increasing the number of stages of cascade connected filters and the number of taps.

Furthermore, according to a further aspect of the present invention, it is possible to arbitrarily widen the band width by only cascade connecting unit filters so as to satisfy the relationship:

$a * YF^i - b * YF^j$ (a, b, i, j: coefficients, $a > b$, $i < j$)

Furthermore, according to a still further aspect of the present invention, a high-pass filter and low-pass filter are designed in such a way that the respective pass bands overlap with each other in the pass band of the unit filter having a relatively wide pass band, and the operation of narrowing the band width or operation of widening the band width is performed on one or both of the high-pass filter and low-pass filter, and therefore it is possible to fine-adjust the band width simply.

[Brief Description of the Drawings]

FIGS. 1A and 1B are diagrams showing the circuit structure of four types of basic unit filters F0 to F3 which constitute the basis of the filter designing method of this embodiment and numeric strings of the respective filter coefficients;
FIGS. 2A and 2B are diagrams showing the generation algorithm and circuit structure of a low-pass unit filter L10;
FIGS. 3A and 3B are diagrams showing the generation algorithm and circuit structure of a low-pass unit filter L11;
FIG. 4 is a diagram showing the frequency-gain characteristics of the low-pass unit filters L10, L11;
FIG. 5 is a diagram showing the frequency-gain characteristic of a low-pass unit filter $(L10)^m$;
FIGS. 6A and 6B are diagrams showing the generation algorithm and circuit structure of a high-pass unit filter H10;
FIG. 7 is a diagram showing the frequency-gain characteristics of the high-pass unit filters H10, H11;
FIG. 8 is a diagram showing the frequency-gain characteristic of a high-pass unit filter $(H10)^m$;
FIGS. 9A and 9B are diagrams schematically showing a band pass filter designing method according to this embodiment;
FIG. 10 is a diagram showing a specific design example of the band pass filter according to this embodiment;
FIG. 11 is a diagram showing a specific design example of the band pass filter according to this embodiment;
FIG. 12 is a diagram showing an example of the circuit structure of the band pass filter according to this embodiment;
FIGS. 13A to 13C are diagrams showing the frequency-gain characteristics of the band pass filter shown in FIG. 12;
FIGS. 14A and 14B are diagrams schematically showing means for narrowing a band width;
FIG. 15 is a diagram schematically showing means for widening a band width;
FIG. 16 is a diagram showing an example of the frequency-gain characteristic resulting from adjusting the band width of the high-pass unit filter H18; and
FIGS. 17A and 17B are diagrams schematically showing means for fine-adjusting a band width.

[Detailed Description of the Preferred Embodiments]

Before explaining an embodiment of the present invention, an overview of Japanese Patent Application No. 2001-400673 (hereinafter referred to as "previous application") already applied by the present applicant will be explained below. According to this previous application, four types of unit filters L1n, L2n, H1n, H2n are created using four types of basic unit filters F0, F1, F2, F3 which will be explained below so as to make it possible to design an FIR filter having a desired frequency characteristic by only combining these unit filters.

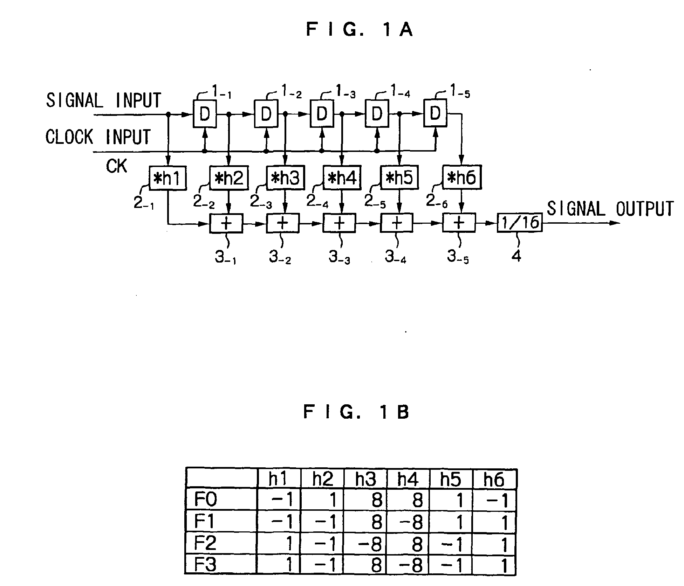

FIGS. 1A and 1B are diagrams showing the four types of basic unit filters F0 to F3; FIG. 1A shows the circuit structure and FIG. 1B shows numeric strings of filter coefficients. As shown in FIG. 1A, in the basic unit filters F0 to F3, five cascade connected D-type flip flops $1_{-1}$ to $1_{-5}$ delay an input signal sequentially by 1 clock CK at a time. Then, the signals extracted from the input/output taps of the respective D-type flip flops $1_{-1}$ to $1_{-5}$ are multiplied by integer values h1 to h6 resulting from multiplying the filter coefficients 16-fold using six coefficient multipliers $2_{-1}$ to $2_{-6}$ respectively and all the multiplication results are added up using five adders $3_{-1}$ to $3_{-5}$. Furthermore, by multiplying the addition output 1/16-fold using a multiplier 4 provided at the output stage of the adder $3_{-5}$ at the final stage, the signal is output with the amplitude returned to the original state.

All of the four types of basic unit filters F0 to F3 have the circuit structure shown in FIG. 1A and only the filter coefficients (multiplier values h1 to h6 of coefficient multipliers $2_{-1}$ to $2_{-6}$) are different as shown in FIG. 1B. As is evident from FIG. 1B, the filter coefficients of the basic unit filters F0 to F3 consist of extremely simple numeric strings using only "1" or "8" as absolute value and those strings are differentiated by adding positive or negative signs. However, in all the coefficients of the basic unit filters F0 to F3, the absolute values of multiplier values h3, h4 corresponding to the taps close to the center are "8", while the absolute values of multiplier values h1, h2, h5, h6 corresponding to the taps on both sides are "1".

Unit filters L1n, L2n, H1n, H2n are generated using these basic unit filters F0 to F3. The suffix "n" to each numeral indicating the unit filter denotes the number of clocks of a delay to be inserted between taps, that is, the number of "0"s to be inserted between filter coefficients (which will be explained in detail later).

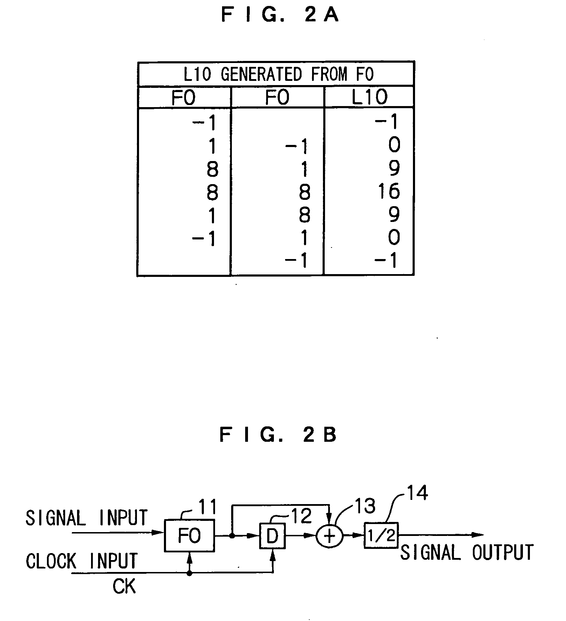

FIGS. 2A and 2B are diagrams showing a low-pass unit filter L10; FIG. 2A shows a method of generating the low-pass unit filter L10 and FIG. 2B shows the circuit structure. As shown in FIG. 2A, the low-pass unit filter L10 is generated by carrying out a moving average calculation on the filter coefficients of the basic unit filter F0 one time.

According to the circuit structure, as shown in FIG. 2B, a D-type flip flop 12 connected after a basic unit filter (F0) 11 delays the output signal of the basic unit filter 11 by 1 clock CK, an adder 13 adds up the signals before and after being delayed by the D-type flip flop 12 and a multiplier 14 multiplies the addition output 1/2-fold so as to output the signal with the amplitude returned to the original value.

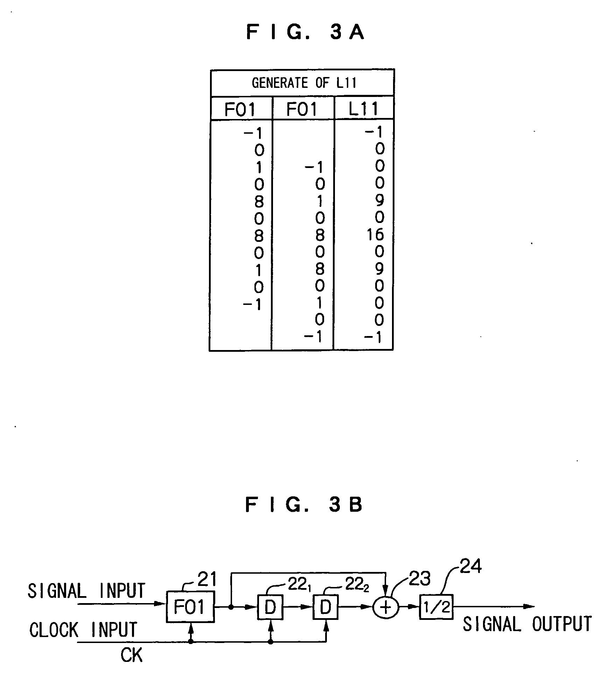

FIGS. 3A and 3B are diagrams showing a low-pass unit filter L11; FIG. 3A shows a method of generating the low-pass unit filter L11 and FIG. 3B shows the circuit structure. The filter coefficients of the low-pass unit filter L11 are generated by inserting one "0" between the respective filter coefficients of the aforementioned low-pass unit filter L10. That is, as shown in FIG. 3A, the filter coefficients of the low-pass unit filter L11 are generated by carrying out a moving average calculation on the filter coefficients of the basic unit filter F01 one time.

According to the circuit structure of the low-pass unit filter L11, as shown in FIG. 3B, two D-type flip flops $22_{-1}$, $22_{-2}$ cascade connected after a basic unit filter (F01) 21 delay the output signal of the basic unit filter 21 sequentially by 1 clock CK at a time. Then, an adder 23 adds up the signals before and after being delayed by the D-type flip flops $22_{-1}$, $22_{-2}$ and a multiplier 24 multiplies the addition output 1/2-fold so as to output the signal with the amplitude returned to the original value.

Likewise, the filter coefficients of a low-pass unit filter L1n (n = 2, 3, ... ) are generated by inserting n "0"s between the respective filter coefficients of the low-pass unit filter L10.

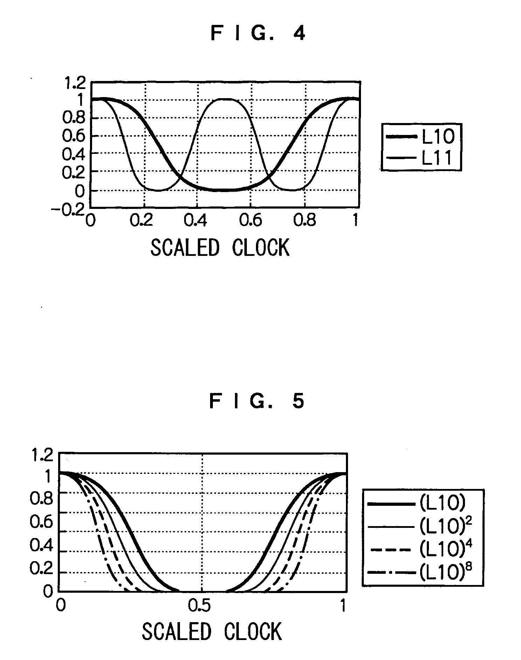

FIG. 4 is a diagram showing the frequency-gain characteristics of the low-pass unit filters L10, L11. Here, gain and frequency are scaled by "1". As is evident from this FIG. 4, when the number of "0"s to be inserted between filter coefficients is n, the frequency axis (period with respect to the frequency direction) of the frequency-gain characteristic becomes 1/n.

Next, the cascade connection of unit filters will be explained. By cascade connecting low-pass unit filters, coefficients of the respective unit filters are mutually multiplied and added and new filter coefficients are created. Hereafter, suppose when, for example, the number of cascade connections of the low-pass unit filter L10 is m, this will be described as $(L10)^m$.

FIG. 5 is a diagram showing the frequency-gain characteristics of low-pass unit filters L10, $(L10)^2$, $(L10)^4$, $(L10)^8$. In this FIG. 5, gain and frequency are also scaled by "1". When there is only one low-pass unit filter L10, the clock at a position at which the amplitude becomes 0.5 is 0.25. In contrast to this, as the number of cascade connections m increases, the band pass width of the filter becomes narrower. For example, when m = 8, the clock at a position at which the amplitude becomes 0.5 is 0.125.

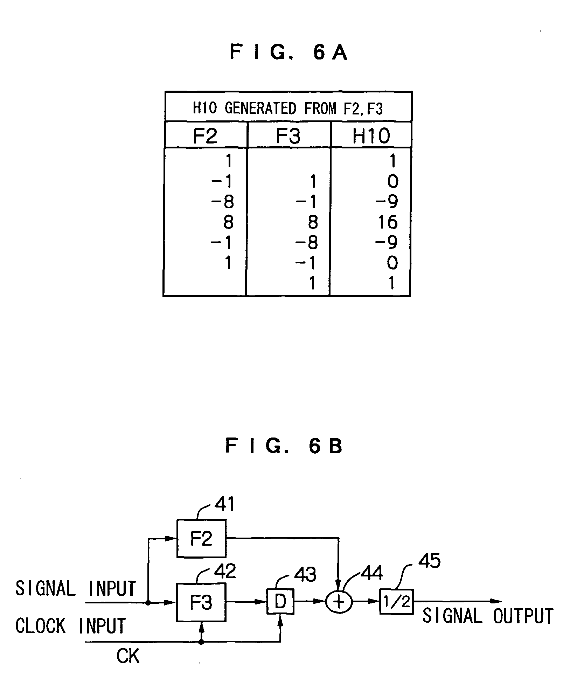

FIGS. 6A and 6B are diagrams showing a high-pass unit filter H10; FIG. 6A shows a method of generating the high-pass unit filter H10 and FIG. 6B shows the circuit structure. As shown in FIG. 6A, the filter coefficients of the high-pass unit filter H10 are generated by carrying out a moving average calculation one time using the filter coefficients of the basic unit filters F2, F3.

According to the circuit structure, as shown in FIG. 6B, an input signal passes through two basic unit filters (F2) 41, (F3) 42 and the output signal of the one basic unit filter 42 is delayed by 1 clock CK by a D-type flip flop 43 connected after the basic unit filter 42. An adder 44 adds up the output signal of the basic unit filter 41 and the output signal of the basic unit filter 42 which has been delayed by 1 clock by the D-type flip flop 43 and a multiplier 45 multiplies the addition output 1/2-fold so as to output the signal with the amplitude returned to the original value.

As in the case of the above described low-pass unit filter L1n, the filter coefficients of a high-pass unit filter H1n (n ≥ 1) are generated by inserting n "0"s between the respective filter coefficients of the high-pass unit filter H10. Furthermore, by cascade connecting m high-pass unit filters H1n, it is possible to create new filter coefficients. In the frequency-gain characteristic of a high-pass unit filter $(H1n)^m$, the band pass width becomes narrower as the number of cascade connections m increases and the gain in the high-frequency region drops extremely deeply and straightly.

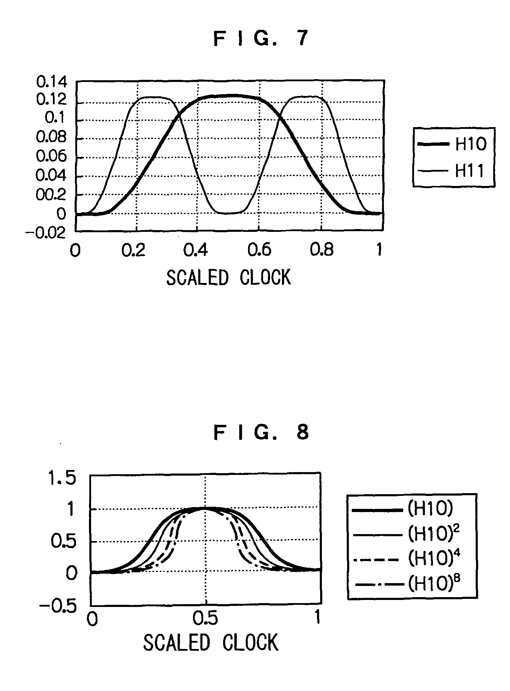

FIG. 7 is a diagram showing the frequency-gain characteristics of the high-pass unit filters H10, H11. In this FIG. 7, gain and frequency are also scaled by "1". As is evident from FIG. 7, in the case of a high-pass unit filter H1n, inserting n "0"s between filter coefficients causes the frequency axis (period with respect to the frequency direction) of the frequency-gain characteristic to become 1/n.

Furthermore, FIG. 8 is a diagram showing the frequency-gain characteristics of the high-pass unit filters H10, $(H10)^2$, $(H10)^4$, $(H10)^8$. In this FIG. 8, gain and frequency are also scaled by "1". When there is only one high-pass unit filter H10, the clock at a position at which the amplitude becomes 0.5 is 0.25. In contrast to this, as the number of cascade connections m increases, the band pass width of the filter becomes narrower. For example, when m = 8, the clock at a position at which the amplitude becomes 0.5 is 0.375.

This is the basic content of the previous application. The filter designing method according to this embodiment will be explained below. Here, an example where a band pass filter having a desired frequency band as a pass band is designed by combining the aforementioned low-pass unit filter L1n and high-pass unit filter H1n will be explained.

When any one of a center frequency Fc of a band pass filter and signal sampling frequency Fs can be determined freely, it is possible to simplify the filter structure by optimizing the condition for pulling out frequencies. Now, suppose the relationship between the center frequency Fc of the band pass filter and signal sampling frequency Fs is:

$$Fs = Fc * (4 + 2k) \qquad (k = 0, 1, 2, ...)$$

In this case, when Fc = 450 KHz, Fs = 1.8 MHz, 2.7 MHz, 3.6 MHz, .... In the case of such a setting, it is possible to design a band pass filter by only cascade connecting a high-pass unit filter H1(5 + 3k) and a low-pass unit filter L1(3 + 2k). Both the high-pass unit filter H1(5 + 3k) and low-pass unit filter L1(3 + 2k) have a pass band whose center frequency Fc becomes 450 KHz.

For example, when k = 0 (Fs = 4Fc), it is possible to design a band pass filter by cascade connecting a high-pass unit filter H15 and a low-pass unit filter L13. Furthermore, when k = 1(Fs = 6Fc), it is possible to design a band pass filter by cascade connecting a high-pass unit filter H18 and a low-pass unit filter L15.

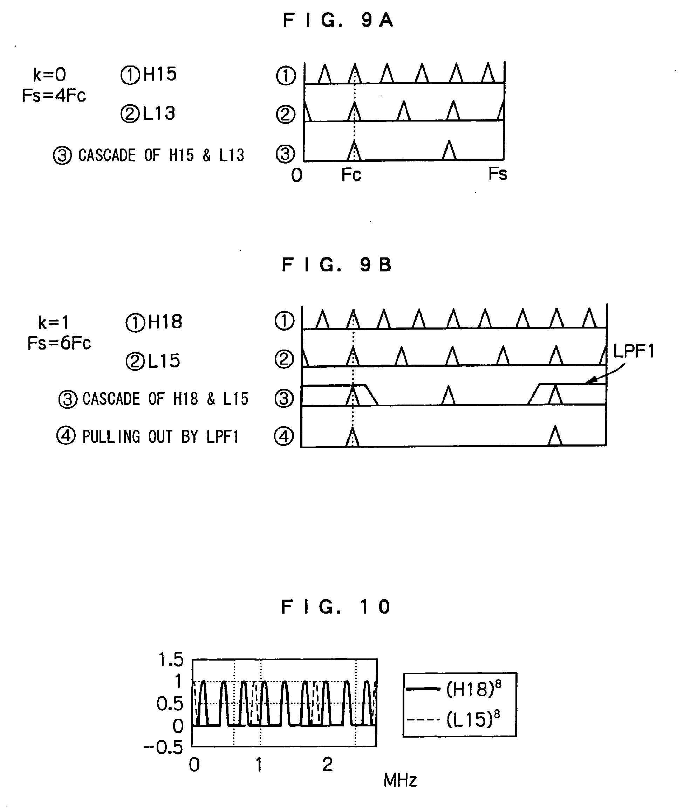

FIGS. 9A and 9B are diagrams schematically showing a method of designing the aforementioned band pass filter; FIG. 9A shows a case where k = 0 and FIG. 9B shows a case where k = 1. For example, in FIG. 9A, when the high-pass unit filter H15 and low-pass unit filter L13 are cascade connected, only the superimposed portions between pass bands (1), (2) can be extracted as a pass band (3).

Likewise in FIG. 9B, when the high-pass unit filter H18 and low-pass unit filter L15 are cascade connected, only the superimposed portions between pass bands (1), (2) can be extracted as a pass band (3), too. When k > 0, pass bands other than the center frequency Fc of the band pass filter to be obtained are generated, and therefore these pass bands are pulled out by a low-pass filter (LPF1) (4).

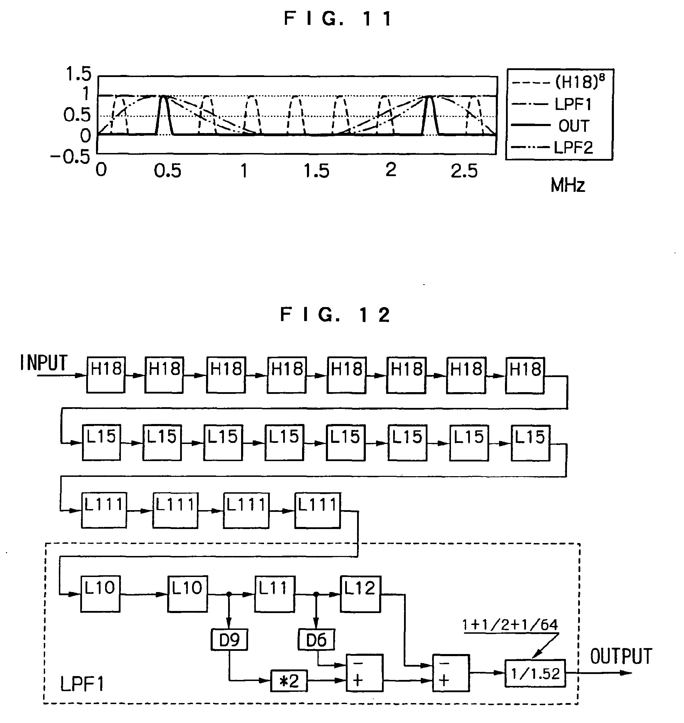

The band width of the band pass filter can be adjusted by the number of cascade connected stages (number of m) of high-pass unit filter $(H1n)^m$ or low-pass unit filter $(L1n)^m$. In the example shown in FIG. 9B, both the high-pass unit filter H18 and low-pass unit filter L15 have m = 1. FIG. 10 and FIG. 11 show the frequency characteristics when m = 8.

FIG. 10 shows the frequency characteristics of the high-pass unit filter $(H18)^8$ and low-pass unit filter $(L15)^8$ superimposed on each other. By cascade connecting these filters, it is possible to extract only the superimposed portions. Furthermore, FIG. 11 shows pulling out of pass bands by the LPF1 or LPF2. By applying the LPF1 or LPF2 to the three band passes extracted as shown in FIG. 10, it is possible to extract only the pass bands at both ends.

Next, an actual circuit example will be shown. Suppose a target standard has a center frequency Fc = 450 KHz, -3 dB band width = 100 KHz, -80 dB band width = 200 KHz. FIG. 12 is a diagram showing a circuit example of a band pass filter which realizes this target standard.

The amount of attenuation of a band pass depends on the number of cascade connected filters. In the circuit shown in FIG. 12, four low-pass unit filters L111 are further cascade connected after eight high-pass unit filters H18 and eight low-pass unit filters L15 to secure an amount of attenuation of 80 dB or more. Low-pass unit filters $(L10)^2$, L11, L12, D-type flip flops D9, D6 and several multipliers and adders that follow these unit filters constitute an LPF1. The D9, D6 mean delays of 9 clocks, 6 clocks, respectively.

As is evident from this FIG. 12, according to the filter designing method of this embodiment, it is possible to obtain a band pass filter having a desired characteristic in an extremely simple structure consisting of a repetition of substantially the same unit filter. Furthermore, the internal structure of each unit filter is as described above, the total number of taps required is 144, which is very few in number. Furthermore, filter coefficients necessary for each tap output are of only four types of -1/16, 1/16, -8/16, 8/16, and since -8/16 = -1/2, 8/16 = 1/2 in particular, it is possible to simplify the calculation circuit considerably.

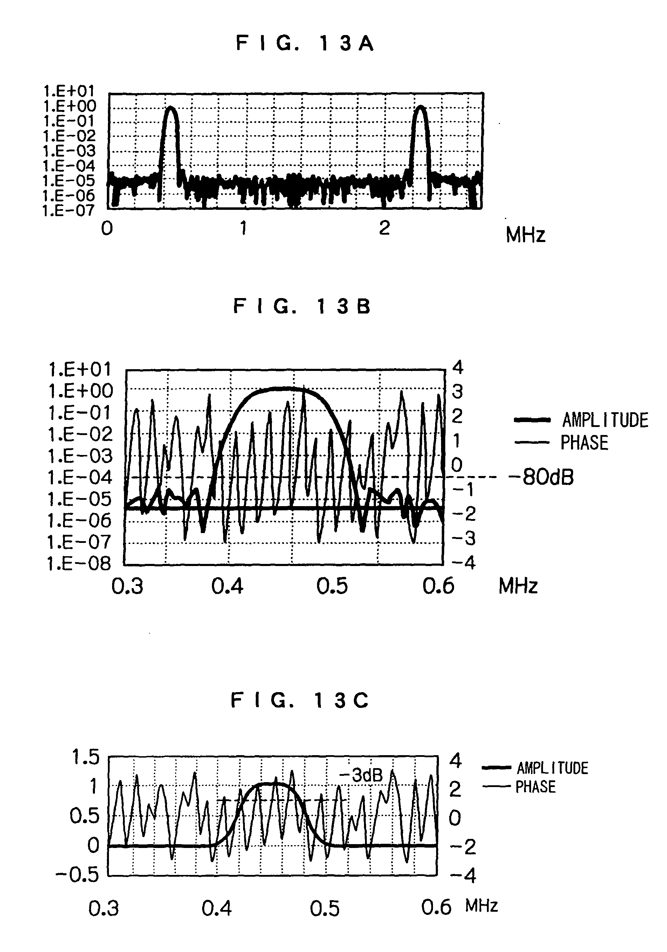

FIGS. 13A to 13C are diagrams showing the frequency-gain characteristic of the band pass filter constructed as shown in FIG. 12. FIG. 13A shows the overall frequency characteristic and shows the gain on a logarithmic scale. FIGS. 13B and 13C show enlarged views of a portion of the pass band; FIG. 13B shows the gain on a logarithmic scale and FIG. 13C shows the gain on a linear scale.

As is evident from FIG. 13A, the band pass filter constructed as shown in FIG. 12 can realize an amount of attenuation of 80 dB or more. However, the band width at -3 dB is approximately 63 KHz and the band width at -80 dB is approximately 145 KHz, which do not satisfy required specifications. In the circuit in FIG. 12, k = 1 (Fs = 6Fc), but when a greater band width is required, it is possible to set $k \geq 2$ and increase the sampling frequency Fs.

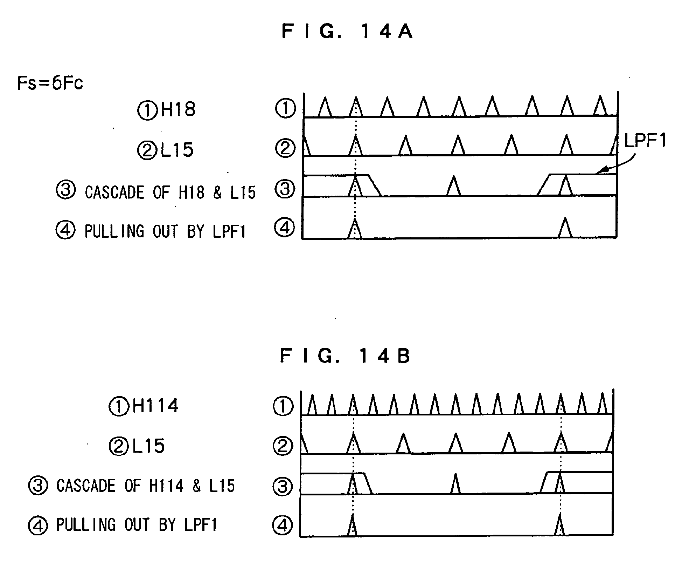

Next, adjusting means for narrowing a band width will be explained. As described above using FIG. 5 and FIG. 8, the number of stages of cascade connected filters can be increased to narrow the band width, which however has a limit. Here, a method capable of narrowing the band width more efficiently will be explained. FIG. 14 schematically shows the method.

FIG. 14A is the same as FIG. 9B. To obtain a narrower band width than this, a high-pass unit filter H114 is used instead of the high-pass unit filter H18 as shown in FIG. 14B. Just like the high-pass unit filter H18, the high-pass unit filter H114 has a pass band with a center frequency Fc of 450 KHz. Besides, the band width of the high-pass unit filter H114 is 9/15 = 3/5 of that of the high-pass unit filter H18.

Therefore, using this high-pass unit filter H114 allows the band width to be narrowed efficiently without increasing the number of stages of cascade connected filters. Furthermore, since the high-pass unit filter H114 has simply increased the number of "0"s to be inserted between the respective filter coefficients, the number of taps to be actually extracted as coefficients does not increase at all and the circuit scale does not expand either. Here, an example of using the high-pass unit filter H114 has been explained, but any unit filter having a pass band at the same center frequency Fc = 450 KHz can be used likewise.

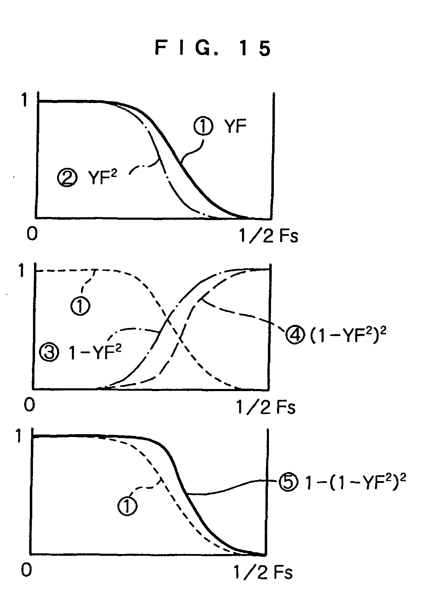

Next, adjusting means for widening the band width will be explained. FIG. 15 is a frequency-gain characteristic diagram to show a method of adjusting a band width including a gradient. In this FIG. 15, the gain is also scaled by "1". Here, suppose the frequency characteristic of the unit filter before adjustment is expressed by YF. As described above, when two unit filters YF shown in (1) are cascade connected, the gradient becomes steeper and the band with becomes narrower (the clock position at -6 dB is shifted toward the lower frequency side) ((2)).

Then, the frequency-gain characteristic of the unit filter $YF^2$ shown in (2) is inverted using the central value (= 0.5) of the gain as the axis ((3)). This can be obtained by subtracting the filter coefficients of the unit filter $YF^2$ from a unit pulse having a reference gain value of "1" (corresponding to a filter coefficient having a central value being "1" and all others being "0") $(1-YF^2)$ after adjusting the delay. Here, this will be called an "inverted unit filter."

Furthermore, two inverted unit filters shown in (3) are cascade connected. The gradient of the frequency-gain characteristic obtained in this way becomes further steeper and the band width also becomes narrower (the clock position at -6 dB moves toward a high frequency side) ((4)). Here, the number of cascade connected inverted unit filters is assumed to be 2 as in the case of (2), but increasing this number can increase the amount of movement toward the high frequency side compared to the amount of movement toward the low frequency side which has been described above.

Finally, the frequency-gain characteristic shown in (4) is inverted using the central value of the gain (= 0.5) as the axis ((5)). This can be calculated by subtracting the filter coefficient in (4) from the unit pulse having a reference gain value of "1" $(1-(1-YF^2)^2)$ after adjusting the delay. When the frequency characteristic of the original data (1) is compared with the frequency characteristic of the adjusted data (5), the gradient of the frequency characteristic of the adjusted data (5) becomes steeper than that of the original data (1) and the band width becomes wider.

The expression of the adjusted data (5) is developed as follows:

$$1 - (1 - YF^2)^2$$

$$= 1 - 1 + 2YF^2 - YF^4$$

$$= 2YF^2 - YF^4 \quad \ldots \text{(Expression 1)}$$

This Expression 1 is the expression obtained when two unit filters in (1) and two inverted unit filters in (3) are cascade connected, but the number of cascade connected stages is not limited to this. However, to widen the band width, it is more desirable to make more the number of cascade connected stages in (3) than the number of cascade connected stages in (1).

In this case, the above described Expression 1 can be generalized as Expression 2 shown below:

$$a * YF^i - b * YF^j \qquad \text{(Expression 2)}$$

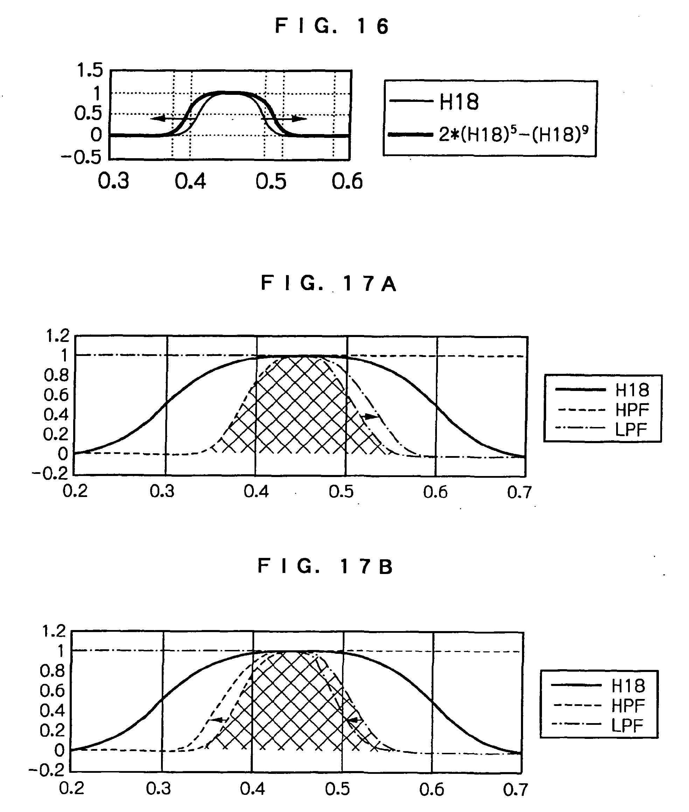

where a, b denote coefficients (a > b), i < j, and * denotes a cascade connection. FIG. 16 shows an example of the result of adjusting this band width using the high-pass unit filter H18 as the original data before adjustment. Here, the adjusted filter is assumed to be:

$$2 * (H18)^5 - (H18)^9$$

Because of this adjustment, the band width at -3 dB is approximately 100 KHz and the band width at -50 dB is approximately 200 KHz.

Next, the means for fine-adjusting the frequency of the band width will be explained. FIGS. 17A and 17B show frequency-gain characteristic diagrams for illustrating a method of fine-adjusting the frequency. In this FIG. 17, the gain is also scaled by "1".

As shown in FIG. 17, a high-pass filter (HPF) and a low-pass filter (LPF) are designed so that pass bands overlap with each other in a relatively wide pass band of the high-pass unit filter H18. By cascade connecting these filters H18, HPF, LPF, it is possible to obtain a band pass filter in which a superimposed portion of the respective pass bands (diagonally shaded area) becomes a pass band.

At this time, by carrying out an operation of narrowing the pass band as shown in FIG. 5 and FIG. 8 or FIG. 14 or an operation of widening the pass band as shown in FIG. 15 and FIG. 16 on any one or both of the high-pass filter HPF and low-pass filter LPF, it is possible to arbitrarily fine-adjust the band width of the band pass filter.

FIG. 17A shows an example of shifting only one side of the band pass filter toward the high frequency side by carrying out an operation of widening the pass band on the low-pass filter LPF. On the other hand, FIG. 17B shows an example of shifting both sides of the band pass filter toward the low frequency side without changing the band width by carrying out an operation of widening the pass band on the high-pass filter HPF and at the same time carrying out an operation of narrowing the pass band on the low-pass filter LPF.

The apparatus for realizing the digital filter designing method according to this embodiment described above can be implemented by any one of a hardware structure, DSP or software. For example, when the apparatus is implemented by software, the filter designing apparatus of this embodiment is actually constructed of a CPU or MPU, RAM, ROM, etc., of a computer and can be implemented by operating a program stored in the RAM or ROM or hard disk, etc.

Therefore, it is possible to realize the apparatus by recording a program which causes the computer to operate so as to execute the functions of this embodiment in a recording medium such as a CD-ROM and causing the computer to read the program. In addition to the CD-ROM, the recording medium for recording the aforementioned program can be a flexible disk, hard disk, magnetic tape, optical disk, magneto-optical disk, DVD, non-volatile memory card, etc. The apparatus can also be implemented by downloading the above described program to the computer via a network such as the Internet.

That is, it is possible to store filter coefficients about various types of unit filters L1n, H1n, etc., as information in a memory such as RAM or ROM, cause the CPU, when the user instructs an arbitrary combination about the unit filters L1n, H1n, etc., to calculate filter coefficients corresponding to the instructed combination using the information on filter coefficients stored in the memory.

For example, it is also possible to iconize various types of unit filters L1n, H1n (storing filter coefficients as information corresponding to each icon) so that the user can arbitrarily combine and arband these icons on the display screen and cause the CPU to automatically calculate and acquire the filter coefficient corresponding to the string of filter coefficients. Furthermore, if the calculated filter coefficient is automatically FFT-transformed and the result is displayed as a frequency-gain characteristic diagram, it is possible to confirm the characteristic of the designed filter and design filters more easily.

In not only the case where the functions of the above described embodiment are realized by the computer executing the supplied program but also a case where the functions of the above described embodiments are realized by the program in cooperation with the OS (operating system) or other application software, etc., operating on the computer or a case where the functions of the above described embodiment are realized by all or part of the processing of executing the supplied program on a function expansion board or function expansion unit of the computer, such a program is included in the embodiment of the present invention.

As detailed above, this embodiment uses one or more unit filters based on basic unit filters having a predetermined basic numeric string as filter coefficients, cascade connects these unit filters to design an FIR filter having a desired frequency characteristic. Thus, it is possible to generate complicated filter coefficients of band pass filters by substantially only combining unit filters. Therefore, the filter designing method is simple and easily comprehensible so that even non-expert technicians can design filters extremely easily.

Furthermore, since the filter circuit designed by applying this embodiment requires a very small number of taps and requires only four types of filter coefficients of -1/16, 1/16, -8/16, 8/16 for each tap output, it is possible to make the structure of the filter circuit extremely simple. Therefore, it is possible to drastically reduce the number of circuit elements (especially of multipliers), reduce the scale of the filter circuit and reduce both power consumption and calculation load, etc.

Furthermore, since the filter circuit designed by applying this embodiment has an extremely simple structure consisting of a repetition of substantially the same pattern, it is possible to reduce man-hours for integration and facilitate the integration into an IC. Furthermore, in the aspect of the characteristic, it is possible to make quite a large improvement in a cutoff characteristic and obtain a linear and excellent filter characteristic in the phase characteristic, too.

Furthermore, when any one of the center frequency Fc of the band pass filter or signal sampling frequency Fs can be freely determined, this embodiment allows a band pass filter to be designed by only cascade connecting the high-pass unit filter H1(5 + 3k) and low-pass unit filter L1(3 + 2k). This eliminates the necessity for extracting necessary frequency bands by canceling out characteristic values which combine several types of unit filters, allows a band pass filter to be designed extremely easily and can make the filter structure simpler.

In this case, by designing a band pass filter with unit filters having the same filter center frequency Fc and more "0"s inserted between filter coefficients (large k value) cascade connected, it is possible to efficiently narrow the band width without increasing the number of stages of cascade connected filters or the number of taps. That is, it is possible to simply narrow the band width without increasing the circuit scale of the filter.

Furthermore, this embodiment also allows the band width to be arbitrarily widened by only cascade connecting the unit filters in such a way as to satisfy the relationship:

$$a * (H1n)^i - b * (H1n)^j$$

or

$$a * (L1n)^i - b * (L1n)^j$$

(a, b, i, j: coefficients; a > b, i < j)

Furthermore, using the operation of widening the band width and operation of narrowing the band width makes it possible to simply fine-adjust the band width. This makes it possible to realize a desired frequency characteristic more accurately and design the FIR digital filter having such a frequency characteristic more easily.

The above described embodiment has shown L0 to L3 as examples of basic unit filters, but the present invention is not limited to this. That is, it is also possible to use numeric values having absolute values of "1" and "8" to set a numeric string different from that in FIG. 1B as filter coefficients of the basic unit filters. Furthermore, the above described embodiment has shown two types; L1n, H1n as examples of the unit filter, but the present invention is not limited to this.

Furthermore, the above described embodiment has used a numeric string with absolute values having a ratio of 1, 1, 8, 8, 1, 1 as the filter coefficients of the basic unit filters , but it is also possible to use a numeric string with absolute values having a ratio of 1, 0, 9, 16, 9, 0, 1 obtained by moving averaging this numeric string once.

Furthermore, the above described embodiment has mainly explained an example of designing a band pass filter, but it is also possible to design a high-pass filter, low-pass filter, band elimination filter, etc., using similar techniques. The techniques for designing these filters will be explained below in a simple manner.

<When a band pass filter is created>

(1) High-pass unit filters H11 are cascade connected (limited to Fs = 4 * Fc).
(2) A high-pass filter HPF and low-pass filter LPF are used.
(3) Ahigh-pass filter and low-pass filter with respective pass bands overlapping with each other are created. (Mutually overlapping band pass filters are also acceptable.)

<When a high-pass filter is created>

(1) High-pass unit filters H10 are cascade connected.
(2) $(H10)^{m1} * (H11)^{m2}$ is created.

<When a low-pass filter is created>

(1) Low-pass unit filters L10 are cascade connected.
(2) $(L10)^{m1} * (L11)^{m2}$ is created.

<When a band elimination filter is created>

(1) The frequency-gain characteristic of a band pass filter is inverted using the central value of the gain as the axis. More specifically, a maximum value of coefficients of the band pass filter is subtracted from a reference gain value of "1" and the polarities of other coefficients are inverted. This is obtained by subtracting the filter coefficient of the band pass filter from a unit pulse having a reference gain value of "1" after adjusting the delay.

Furthermore, it is also possible to design a digital filter by dividing the filter string generated using the above described designing method into one or more blocks and cascade connecting one or more filters which are final generation coefficients for each block.

In addition, all the above described embodiments have only shown specific examples in implementing the present invention and this should not cause the technological scope of the present invention to be interpreted in a limited way. That is, the present invention can be implemented in various forms without departing from the spirit ormain characteristics thereof.

[Industrial Applicability]

The present invention is useful for realizing a desired frequency characteristic at a higher degree of accuracy and enabling an FIR digital filter having such a frequency characteristic to be designed more easily.

**Claims**

1.  A digital filter designing method, comprising:

    creating one or more unit filters having a mutually common pass band based on basic unit filters formed by multiplying respective tap signals of a tapped delay line made up of a plurality of delayers several-fold using filter coefficients made up of a predetermined basic numeric string, adding up those multiplication results and outputting the addition result; and
    cascade connecting said one or more unit filters to thereby design a digital filter.

2.  The digital filter designing method according to claim 1, said one or more unit filters include a high-pass unit filter and a low-pass unit filter having substantially the same center frequency.

3.  The digital filter designing method according to claim 1, the band width of the pass band of said unit filter is narrowed by inserting delays corresponding to a few clocks between said respective taps.

4.  The digital filter designing method according to claim 1, when said unit filter is expressed by YF, said the band width of the pass band of said unit filter is widened by cascade connecting said unit filters so as to satisfy a following relationship:

$$a * Yf^i - b * YF^j$$

    where the multiplications with respect to YF denote cascade connections of said unit filters, a, b, i, j denote coefficients expressing the numbers of cascade connections of said unit filters and $a > b$, $i < j$.

5.  The digital filter designing method according to claim 1, a high-pass filter and a low-pass filter are designed in such a way that their respective pass bands overlap with each other in the relatively wide pass band of the unit filter, said unit filter, said high-pass filter and said low-pass filter are cascade connected to thereby design a band pass filter having a pass band made up of a superimposed portion of the respective pass bands.

6.  A digital filter designing method, comprising:

    creating a unit filter having relatively wide pass band based on basic unit filters formed by multiplying respective tap signals of a tapped delay line made up of a plurality of delayers several-fold using filter coefficients made up of a predetermined basic numeric string, adding up those multiplication results and outputting the addition result;
    designing a high-pass filter and a low-pass filter in such a way that their respective pass bands overlap with each other in the pass band of said unit filter; and
    cascade connecting said unit filter, said high-pass filter and said low-pass filter to thereby design a band pass filter having a pass band made up of a superimposed portion of the respective pass bands.

7.  The digital filter designing method according to claim 5, pass band of said band pass filter is fine-adjusted by carrying out any one or both of processing of inserting delays corresponding to a few clocks between said respective taps on any one or both of said high-pass filter and said low-pass filter to thereby narrow the band width of pass band of said unit filter, and processing of cascade connecting said unit filters so as to satisfy the relationship of a $* YF^i$-b $* YF^j$ (where the multiplications with respect to said unit filter YF denote said cascade connection of said unit filters, a, b, i, j are coefficients indicating the number of the cascade connected unit filters, and $a > b$, $i < j$) to thereby widen the band width of pass band of said unit filter.

8. The digital filter designing method according to claim 6, pass band of said band pass filter is fine-adjusted by carrying out any one or both of processing of inserting delays corresponding to a few clocks between said respective taps on any one or both of said high-pass filter and said low-pass filter to thereby narrow the band width of pass band of said unit filter, and processing of cascade connecting said unit filters so as to satisfy the relationship of a $* YF^i - b * YF^j$ (where the multiplications with respect to said unit filter YF denote said cascade connection of said unit filters, a, b, i, j are coefficients indicating the number of the cascade connected unit filters, and a > b, i < j) to thereby widen the band width of pass band of said unit filter.

9. The digital filter designing method according to claim 1, the filter coefficients of said basic unit filter consists of a numeric string with absolute values having a ratio of 1, 1, 8, 8, 1, 1 or a numeric string with absolute values having a ratio of 1, 0, 9, 16, 9, 0, 1.

10. The digital filter designing method according to claim 1, the filter coefficients of said basic unit filter consists of a numeric string with absolute values having a ratio of 1, 1, 8, 8, 1, 1 or a numeric string with absolute values having a ratio of 1, 0, 9, 16, 9, 0, 1.

11. A digital filter designing program for causing a computer to execute the processing procedure related to the digital filter designing method according to claim 1.

12. A digital filter designing program for causing a computer to execute the processing procedure related to the digital filter designing method according to claim 6.

13. A digital filter designed using the digital filter designing method according to claim 1.

14. A digital filter designed using the digital filter designing method according to claim 6.

15. A digital filter comprising a tapped delay line made up of a plurality of delayers, the respective tap signals are multiplied several-fold by the filter coefficients calculated using the filter designing method according to claim 1, added up those multiplication results and output the addition result.

16. A digital filter comprising a tapped delay line made up of a plurality of delayers, the respective tap signals are multiplied several-fold by the filter coefficients calculated using the filter designing method according to claim 6, added up those multiplication results and output the addition result.

17. A digital filter constructed by cascade connecting one or more unit filters having a common pass band, said unit filters are created based on basic unit filters having a predetermined basic numeric string as filter coefficients.

18. A digital filter constructed by cascade connecting the unit filter having a relatively wide pass band created based on basic unit filters having a predetermined basic numeric string as filter coefficients, a high-pass filter and a low-pass filter created in such a way that their respective pass bands overlap with each other in the pass band of said unit filter.

19. A digital filter designing method for designing digital filters by dividing the filter string created using the designing method according to claim 1 into one or more blocks and cascade connecting one or more filters which are final generation coefficients for each block.

20. A digital filter designing method for designing digital filters by dividing the filter string created using the designing method according to claim 6 into one or more blocks and cascade connecting one or more filters which are final generation coefficients for each block.

21. A digital filter constructed by dividing the filter string created using the designing method according to claim 1 into one or more blocks and cascade connecting one or more filters which are final generation coefficients for each block.

22. A digital filter constructed by dividing the filter string created using the designing method according to claim 6 into one or more blocks and cascade connecting one or more filters which are final generation coefficients for each block.

FIG. 1A

SIGNAL INPUT ━━━━━━━●━━[D]$1_{-1}$━━●━━[D]$1_{-2}$━━[D]$1_{-3}$━━[D]$1_{-4}$━━●━━[D]$1_{-5}$

CLOCK INPUT

CK

[*h1]$2_{-1}$  [*h2]$2_{-2}$  [*h3]$2_{-3}$  [*h4]$2_{-4}$  [*h5]$2_{-5}$  [*h6]$2_{-6}$

[+]$3_{-1}$  [+]$3_{-2}$  [+]$3_{-3}$  [+]$3_{-4}$  [+]$3_{-5}$  [1/16]$4$  SIGNAL OUTPUT

FIG. 1B

|     | h1 | h2 | h3 | h4 | h5 | h6 |
|-----|----|----|----|----|----|----|
| F0  | -1 | 1  | 8  | 8  | 1  | -1 |
| F1  | -1 | -1 | 8  | -8 | 1  | 1  |
| F2  | 1  | -1 | -8 | 8  | -1 | 1  |
| F3  | 1  | -1 | 8  | -8 | -1 | 1  |

12

# F I G. 2 A

| L10 GENERATED FROM F0 | | |
|---|---|---|
| F0 | F0 | L10 |
| −1 | | −1 |
| 1 | −1 | 0 |
| 8 | 1 | 9 |
| 8 | 8 | 16 |
| 1 | 8 | 9 |
| −1 | 1 | 0 |
| | −1 | −1 |

# F I G. 2 B

SIGNAL INPUT → [F0] 11 → [D] 12 → (+) 13 → [1/2] 14 → SIGNAL OUTPUT

CLOCK INPUT CK

## F I G.  3 A

| GENERATE OF L11 | | |
|---|---|---|
| FO1 | FO1 | L11 |
| −1 | | −1 |
| 0 | | 0 |
| 1 | −1 | 0 |
| 0 | 0 | 0 |
| 8 | 1 | 9 |
| 0 | 0 | 0 |
| 8 | 8 | 16 |
| 0 | 0 | 0 |
| 1 | 8 | 9 |
| 0 | 0 | 0 |
| −1 | 1 | 0 |
| | 0 | 0 |
| | −1 | −1 |

## F I G.  3 B

SIGNAL INPUT → [FO1] 21 → [D] 22₁ → [D] 22₂ → (+) 23 → [1/2] 24 → SIGNAL OUTPUT

CLOCK INPUT

CK

F I G. 4

F I G. 5

## F I G. 6 A

| H10 GENERATED FROM F2, F3 | | |
|---|---|---|
| F2 | F3 | H10 |
| 1 | | 1 |
| -1 | 1 | 0 |
| -8 | -1 | -9 |
| 8 | 8 | 16 |
| -1 | -8 | -9 |
| 1 | -1 | 0 |
| | 1 | 1 |

## F I G. 6 B

SIGNAL INPUT

CLOCK INPUT

CK

41 — F2
42 — F3
43 — D
44 — +
45 — 1/2

SIGNAL OUTPUT

F I G. 7

F I G. 8

# F I G. 9 A

k=0
Fs=4Fc

① H15

② L13

③ CASCADE OF H15 & L13

① ② ③

0    Fc            Fs

# F I G. 9 B

k=1
Fs=6Fc

① H18

② L15

③ CASCADE OF H18 & L15

④ PULLING OUT BY LPF1

① ② ③ ④

LPF1

# F I G. 1 0

1.5
1
0.5
0
-0.5

0    1    2

MHz

— $(H18)^8$
---- $(L15)^8$

# F I G. 1 1

# F I G. 1 2

F I G. 1 3 A

F I G. 1 3 B

AMPLITUDE
PHASE

−80dB

F I G. 1 3 C

AMPLITUDE
PHASE

−3dB

# F I G. 1 4 A

Fs=6Fc

① H18

② L15

③ CASCADE OF H18 & L15

④ PULLING OUT BY LPF1

LPF1

# F I G. 1 4 B

① H114

② L15

③ CASCADE OF H114 & L15

④ PULLING OUT BY LPF1

## F I G. 1 5

F I G.  1 6

F I G.  1 7 A

F I G.  1 7 B

## INTERNATIONAL SEARCH REPORT

| International application No. |
| --- |
| PCT/JP03/08922 |

**A. CLASSIFICATION OF SUBJECT MATTER**
Int.Cl$^7$ H03H17/06

According to International Patent Classification (IPC) or to both national classification and IPC

**B. FIELDS SEARCHED**

Minimum documentation searched (classification system followed by classification symbols)
Int.Cl$^7$ H03H17/00-17/08

Documentation searched other than minimum documentation to the extent that such documents are included in the fields searched

| | | | | |
| --- | --- | --- | --- | --- |
| Jitsuyo Shinan Koho | 1922-1996 | Toroku Jitsuyo Shinan Koho | 1994-2003 |
| Kokai Jitsuyo Shinan Koho | 1971-2003 | Jitsuyo Shinan Toroku Koho | 1996-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 63-269613 A (Kenwood Corp.), | 1,11,13,15, |
| | 07 November, 1988 (07.11.88), | 17-19,21 |
| Y | Page 3, upper right column, line 19 to page 4, | 3,9-10 |
| A | lower right column, line 16; Figs. 1 to 3 | 2,4-8,12,14, |
| | (Family: none) | 16,20,22 |
| Y | JP 6-503450 A (LUNNER, Thomas HELLGREN, Johan), | 3 |
| A | 14 April, 1994 (14.04.94), | 7-8 |
| | Page 3, lower left column, line 18 to page 4, | |
| | upper left column, line 7; Figs. 3, 5 to 6 | |
| | & WO 92/11696 A & EP 574400 B | |
| | & US 5436859 A | |
| Y | JP 6-326555 A (Sony United Kingdom Ltd.), | 9-10 |
| | 25 November, 1994 (25.11.94), | |
| | Par. No. [0022] | |
| | (Family: none) | |

| | | |
| --- | --- | --- |
| ☒ Further documents are listed in the continuation of Box C. | ☐ See patent family annex. | |

\* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 17 September, 2003 (17.09.03) | 07 October, 2003 (07.10.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

**EP 1 533 898 A1**

<table>
<tr><td colspan="2">INTERNATIONAL SEARCH REPORT</td><td>International application No.<br>PCT/JP03/08922</td></tr>
<tr><td colspan="3">C (Continuation).   DOCUMENTS CONSIDERED TO BE RELEVANT</td></tr>
<tr><td>Category*</td><td>Citation of document, with indication, where appropriate, of the relevant passages</td><td>Relevant to claim No.</td></tr>
<tr><td>A</td><td>JP 5-243908 A   (NEC Corp.),<br>21 September, 1993 (21.09.93),<br>Par. No. [0003]; Fig. 2<br>(Family: none)</td><td>4,7-8</td></tr>
<tr><td>A</td><td>JP 63-103509 A   (Sony Corp.),<br>09 May, 1988 (09.05.88),<br>Page 3, upper left column, line 3 to upper right column, line 18; Fig. 3<br>(Family: none)</td><td>5-8,12,14,<br>16,20,22</td></tr>
</table>

Form PCT/ISA/210 (continuation of second sheet) (July 1998)